# EUROPEAN PATENT SPECIFICATION

(11) **EP 1 630 858 B1**
(45) Date of publication and mention of the grant of the patent: **15.02.2012**
(21) Application number: 04717277.0
(22) Date of filing: 04.03.2004
(51) Int. Cl.: H01L 21/00, H01L 21/02

(54) **SUBSTRATE PROCESSING SYSTEM**
SUBSTRATVERARBEITUNGSSYSTEM
SYSTEME DE TRAITEMENT DE SUBSTRAT

(30) Priority: 04.03.2003 JP 2003057202
(43) Date of publication of application: 01.03.2006
(73) Proprietor: TOKYO ELECTRON LIMITED, Minato-ku Tokyo 107-6325 (JP); Ohmi, Tadahiro, Sendai-shi, Miyagi 980-0813 (JP)
(72) Inventor: OHMI, Tadahiro, Sendai-shi, Miyagi 980-0813 (JP); TERAMOTO, Akinobu, Sendai-shi, Miyagi 980-0037 (JP)
(74) Representative: Goddar, Heinz J.
(86) International application number: PCT/JP2004/002705
(87) International publication number: WO 2004/079808

(56) References cited:
- WO-A-03/017359
- JP-A- 3 116 730
- JP-A- 4 014 222
- JP-A- 11 288 989
- JP-A- 11 307 507
- JP-A- 2001 199 715
- JP-A- 2002 176 026
- JP-A- 2002 237 482
- JP-A- 2002 289 668
- US-A1- 2003 032 292

## Description

### Technical Field

The present invention relates to a substrate processing system and a manufacturing method of a semiconductor device.

### Background Art

In the preceding process in the manufacturing process of a semiconductor device, for example, film forming processing is performed in which a gate insulating film and a gate electrode film are formed on the wafer surface.

The film forming processing of the gate insulating film and the gate electrode film is generally performed in film forming units such as a CVD unit in which a material in a gas state or in a plasma state is supplied to a wafer in a reduced-pressure environment to deposit a thin film on the wafer surface through a chemical catalyst reaction on the wafer surface, and a sputtering unit in which the film material is sputtered by ion bombardment to physically deposit a thin film on the wafer surface.

Incidentally, before the film forming processing is performed on the wafer in the film forming unit, cleaning treatment of the wafer is performed for removing impurities such as an organic material and metal adhering to the wafer. This is because if impurities adhere to the wafer, the impurities interfere with the film formation, whereby a desired film is not formed on the wafer. The cleaning treatment is performed by supplying a cleaning solution to the wafer in a cleaning unit provided independent from the film forming unit. In the cleaning unit, after the wafer is cleaned with the cleaning solution, for example, shaking-off drying of the wafer is performed by rotating the wafer at a high speed to dry it (for example, Japanese Patent Application Laid-open No. 2002-219424).

Accordingly, the wafer has been conventionally cleaned with the cleaning solution and dried by shaking-off in the above-described cleaning unit, and then carried to the film forming unit so that a film is formed on the wafer.

However, the shaking-off drying performed in the above-described cleaning unit has, in fact, not completely removed the water adhering to the wafer. Further, water in the atmospheric air may have adhered to the wafer during carriage of the wafer from the cleaning unit to the film forming unit. If the film forming processing is performed with water remaining on the wafer as described above, the water interferes with the film formation in the above-described film forming unit, inhibiting formation of a film with a good quality film. In particular, the film thickness has been increasingly reduced to about several nm recently, and therefore adherence of water even in a small amount greatly affects the firm formation. Although there also is a dry-type cleaning unit using no cleaning solution, the unit typically has a cleaning ability lower than that of a wet-type and has an inherent problem of incapability of sufficiently removing impurities. Consequently, it is desirable to use the wet-type cleaning unit.

US2003/032292 A1, WO 03/017359 A and JP-A-4 014 222 disclose a cleaning unit for cleaning a substrate with a cleaning solution. They further disclose a water removing unit for removing water adhering to the substrate cleaned in the cleaning unit, and a carrier section for carrying the substrate from which water has been removed in said water removing unit to another substrate processing unit through a dry atmosphere.

### Disclosure of the Invention

The present invention has been developed in consideration of the above viewpoint, and its object is to provide a substrate processing system and method capable of completely removing water adhering to a substrate such as a wafer due to cleaning and carrying the substrate with the water being removed, to another processing unit such as a film forming unit, and a manufacturing method of a semiconductor device.

The object is solved by a substrate processing system as defined in claim 1. Preferred embodiments are subject-matter of subclaims.

To achieve the above object, the substrate processing system of claim 1 is defined by including: a cleaning unit for cleaning a substrate with a cleaning solution; a water removing unit for removing water adhering to the substrate cleaned in the cleaning unit; and a carrier section for carrying the substrate from which water has been removed in the water removing unit to another substrate processing unit through a dry atmosphere.

Specifically, the substrate cleaned in the cleaning unit is dried by a dedicated water removing unit, and the dried substrate is carried to another processing unit through a dry atmosphere. Accordingly, it is possible to completely remove water from the substrate, carry the substrate with the water being removed, and then process it in the other processing unit.

As a result of this, appropriate processing can be performed without interference by water in the processing unit to which the substrate is carried.

The cleaning unit may be connected with the water removing unit, the water removing unit is selectively connected with the carrier section, and the carrier section may be connected with the other processing unit. In this case, continuous carriage of the substrate is smoothly performed from the cleaning unit to the water removing unit, the carrier section, and other processing unit. Incidentally, the carrier section may be connected with a carry-in/out section for carrying-in/out the substrate to/from the substrate processing system from/to the outside.

The substrate processing system of the present invention further includes a shutter for opening/closing a carrier port for the substrate between the water removing unit and the carrier section; and a control unit to which the measurement result of the water concentration is outputted from the water concentration measuring member, for controlling opening/closing of the shutter based on the measurement result. In this case, for example, only when the water concentration in the water removing unit becomes the threshold value or less, the shutter can be opened. Accordingly, the substrate is never carried out of the water removing unit by mistake before water is sufficiently removed from the substrate, whereby a substrate on which water remains can be prevented from being processing in the other unit.

The water removing unit may have a heating member for heating the substrate. In this case, by heating the substrate, the water adhering to the substrate can be removed with more reliability.

The heating member may heat the substrate by radiation. In this case heat can be supplied to the substrate from a position apart therefrom to uniformly heat the substrate surface without unevenness, thereby removing the water within the substrate surface without fail.

The water removing unit may include a rotary mechanism for rotating the substrate. This rotary mechanism can rotate the substrate to which, for example, the high-temperature gas is being supplied to dry the substrate more uniformly.

The water removing unit may include a high-temperature gas supply unit for supplying a high-temperature gas to the substrate. In this case, the high-temperature gas can surely remove the water adhering to the substrate surface. Note that the high-temperature gas refers to a gas at a temperature higher than room temperature. It is preferable that the high-temperature gas is a gas with an oxygen concentration of 4 ppm or less. Note that the water removing unit with the high-temperature gas supply unit may include a rotary mechanism for rotating the substrate.

The water removing unit may include a water concentration measuring member for measuring the water concentration in the water removing unit. In this case, by measuring the water concentration in the water removing unit, for example, during removal of water, it can be confirmed that water no longer exists on the substrate. As a result of this, removal of water can be performed with more reliability. It should be note that the water removing unit may include an exhaust unit for exhausting a gas in the water removing unit and the water concentration measuring member may be provided in the exhaust unit.

The water removing unit may include a pressure reducing unit for reducing the pressure in the water removing unit. The pressure reducing unit can be used to reduce the pressure in the water removing unit to a pressure between the pressure in the cleaning unit and the pressure in the carrier section. Accordingly, the pressure can be gradually reduced when the substrate is carried to the cleaning unit, the water removing unit, and the carrier section in order, thereby reducing the load on the substrate due to a change in pressure.

The water removing unit may be provided with a gas supply unit for supplying a gas other than oxygen gas into the entire water removing unit. The gas supply unit can be used to maintain a low-oxygen atmosphere in the water removing unit, thereby preventing the substrate from being oxidized in the water removing unit in which the film on the substrate deteriorates.

The carrier section may include a casing covering a carrier path of the substrate, and the casing may be provided with a dry gas supply unit for supplying a dry gas into the carrier path. The dry gas can be supplied from the dry gas supply unit to maintain a dry atmosphere in the casing to prevent water from adhering to the substrate during carriage. Note that the dry gas may be a gas other than oxygen gas.

The carrier section may be provided with a pressure reducing mechanism for reducing the pressure of an atmosphere in the carrier path. Further, the pressure reducing mechanism may include a control unit capable of controlling the pressure in the carrier path so that the pressure is between the pressure in the other processing unit and the pressure in the water removing unit. More specifically, the pressure reducing mechanism may include a control unit for controlling such that P₂ < P₁ < P₃ where the pressure in the carrier path is P₁, the pressure in the other processing unit is P₂, and the pressure in the water removing unit is P₃. In this case, even if the processing in the other processing unit is performed, for example, at a high pressure-reduction degree, the reduction degree can be increased in the order of the water removing unit, the carrier section, and the other processing unit, thus preventing breakage of the substrate due to a sudden change in pressure reduction.

The other processing unit may be a film forming unit for forming a film on the substrate. In this case, since the substrate from which water has been removed is carried into the film forming unit, the film forming processing can be performed appropriately. The substrate processing system with the film forming unit may further include a film thickness measuring member for measuring the film thickness of the film formed on the substrate in the film forming unit. The film thickness measuring member can be used to inspect the film thickness of the film formed on the substrate at an earlier stage. Accordingly, if a film is not appropriately formed, the film forming unit can be stopped and its poor condition can be immediately corrected before such substrates are manufactured in large quantities. Note that the other processing unit may be an etching unit.

Further, the cleaning unit may be covered by a housing and may include a gas supply unit for supplying a gas other than oxygen gas into the housing. When water adheres to the substrate in the cleaning unit, oxygen in the peripheral atmosphere comes to easily react with the substrate due to the water. The cleaning unit includes the gas supply unit, which supplies a gas other than oxygen gas into the housing, whereby a low-oxygen atmosphere can be maintained in the housing to suppress the reaction between oxygen and the substrate. Accordingly, it can be prevented, for example, that the film on the substrate is oxidized in which the film deteriorates. Further, the substrate processing system may be configured to be able to atmosphere-control the entire substrate processing system.

Claim 21 defines an alternative aspect of a substrate processing system of the invention which is specifically explained further below.

Further, according to the present invention, a manufacturing method of a semiconductor device for processing a semiconductor substrate through use of a substrate processing system is defined in claim 21.

### Brief Description of the Drawings

Fig. 1 is an explanatory view of a transverse section showing a schematic configuration of a substrate processing system according to the embodiment;
Fig. 2 is an explanatory view of a longitudinal section showing a schematic configuration of a cleaning unit;
Fig. 3 is an explanatory view of a longitudinal section showing a schematic configuration of a water removing unit;
Fig. 4 is a plan view of a chuck of the water removing unit;
Fig. 5 is an explanatory view of a longitudinal section showing a schematic configuration of a first film forming unit;
Fig. 6 is an explanatory view of a longitudinal section showing a schematic configuration of a second film forming unit;
Fig. 7 is an explanatory view of a longitudinal section showing a schematic configuration of a water removing unit with a heater; and
Fig. 8 is an explanatory view of a transverse section showing a schematic configuration of a substrate processing system with a film thickness measuring probe.

### Best Mode for Carrying out the Invention

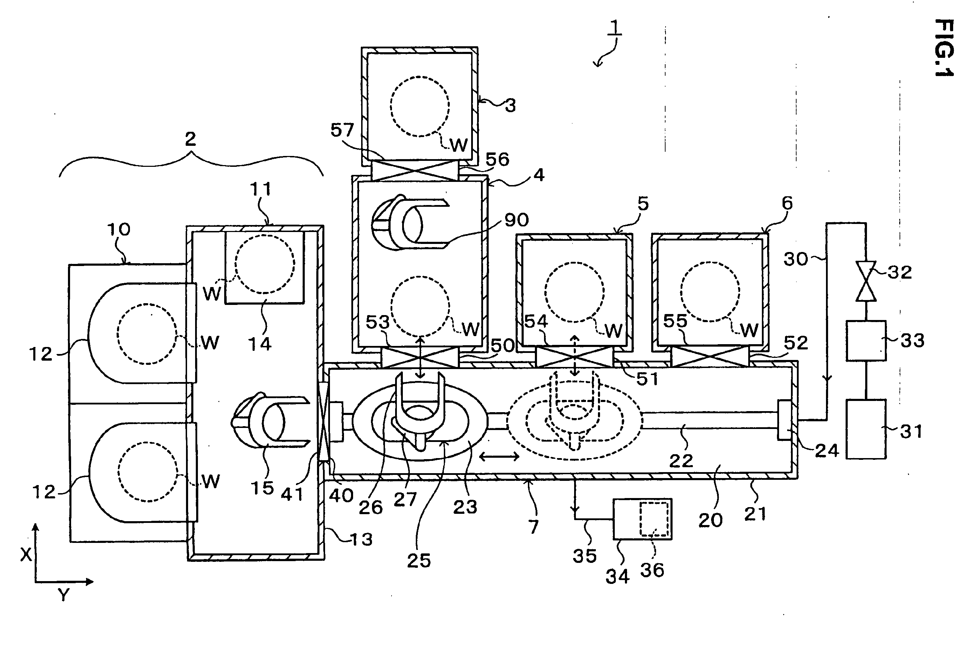

Hereinafter, a preferred embodiment of the present invention will be described. Fig. 1 is a plan view showing a schematic configuration of a substrate processing system 1 according to the embodiment.

The substrate processing system 1 has a configuration in which a carry-in/out section 2 for carrying wafers W from/to the outside into/out of the processing system, a cleaning unit 3 for cleaning the wafer W with a cleaning solution, a water removing unit for removing water adhering to the wafer W, two film forming units 5 and 6 each for forming a predetermined film on the wafer W, and a carrier section 7 for carrying the wafer W between those units and between each of the units and the carry-in/out section 2, are integrally connected.

The carrier section 7 is connected, for example, to the carry-in/out section 2 on the positive direction side in an X-direction (on the right side in Fig. 1). The water removing unit 4, the first film forming unit 5 and the second film forming unit 6 are connected to the rear side of the carrier section 7 that is on the positive direction side in a Y-direction (on the upper side in Fig. 1). To the rear side of the water removing unit 4, the cleaning unit 3 is further connected. In short, the water removing unit 4 is disposed between the cleaning unit 3 and the carrier section 7.

The carry-in/out section 2 has a configuration in which, for example, a cassette mounting table 10 and a carrier chamber 11 are arranged in parallel to each other in the X-direction (the right-left direction in Fig. 1) in one united body. In the cassette mounting table 10, a sealable cassette 12 such as FOUP (Front Opening Unified Pod) can be mounted which houses, for example, 25 wafers W multi-tiered. On the cassette mounting table 10, for example, two cassettes 12 can be mounted along the Y-direction (the top-down direction in Fig. 1).

The carrier chamber 11 is, for example, entirely covered by a case 13 so that clean gas can be supplied into the carrier chamber 11 to keep clean atmosphere in the carrier chamber 11. The carrier chamber 11 is provided with an alignment stage 14 for aligning the wafer W which has been taken out of the cassette 12. The carrier chamber 11 is further provided with a wafer carrier 15 for accessing the cassette 12, the alignment stage 14, and the carrier section 7 to carry the wafer W thereto.

The carrier section 7-has a long carrier path-20 along the X-direction, with one end on the negative direction side in the X-direction of the carrier path 20 connected to the carrier chamber 11 of the carry-in/out section 2. The carrier section 7 includes a casing 21 that covers the whole carrier path 20 and is able to seal the inside. The carrier path 20 is provided with a rail 22 extending along the carrier path 20. On the rail 22, a stage 23 is provided which is movable in the X-direction on the rail 22 by a not-shown motor attached to the rail 22. On the stage 23, a wafer carrier mechanism 25 is provided. The wafer carrier mechanism 25 is freely movable along the X-direction by the stage 23.

The wafer carrier mechanism 25 includes two holding members 26 for holding the wafer W, and an articulated arm 27 for supporting the holding members 26 and movable back and forth in a predetermined horizontal direction. The arm 27 is rotatable in a θ-direction around the vertical axis to be able to direct the holding members 26 in a predetermined direction. Accordingly, the wafer carrier mechanism 25 can move to the front of each of the carry-in/out section 2, the water removing unit 4, and the film forming units 5 and 6 which are connected to the carrier section 7 and move the holding members 26 back and forth in the horizontal direction, thereby carrying-in/out the wafer W to/from each of the carry-in/out section 2, the water removing unit 4, and the film forming units 5 and 6.

To the casing 21 of the carrier section 7, a gas supply pipe 30 is connected as a dry gas supply unit that supplies into the carrier path 20 a dry gas having a water concentration of, for example, 1.2% or less, preferably 0.1 ppm or less. The gas supply pipe 30 leads to a gas supply source 31 located outside the carrier section 7, so that the dry gas is supplied from the gas supply source 31. To the gas supply pipe 30, a valve 32 and a massflow controller 33 are connected so that gas at a predetermined pressure is supplied into the carrier path 20. Note that, in this embodiment, a gas other than oxygen gas, for example, nitrogen gas is used as the dry gas.

To the casing 21 of the carrier section 7, an exhaust pipe 35 is connected which leads to an exhauster 34 such as a vacuum pump located outside the casing 21. The exhauster 34 is provided with a control unit 36 which can control the exhaust pressure so that the pressure inside the casing 21 can be reduced to a predetermined pressure. Note that the exhauster 34, the exhaust pipe 35, and the control unit 36 constitute a pressure reducing mechanism.

At the connecting portion between the carrier section 7 and the carrier chamber 11, a carrier port 40 is provided for carrying the wafer W. The carrier port 40 is provided with a gate valve 41. The gate valve 41 can block the atmosphere in the carrier section 7 from the atmosphere in the carrier chamber 11.

As described above, the water removing unit 4 and the film forming units 5 and 6 are connected to the rear side of the carrier section 7 along its longitudinal direction (X-direction) in order from the carry-in/out section 2 side. At connecting portions between the carrier section 7 and the units 4 to 6, carrier ports 50, 51, and 52 are provided, respectively, and gate valves 53, 54, and 55 are provided at the carrier ports 50 to 52. The gate valves 53 to 55 can block the atmosphere in the carrier section 7 from those in the units 4 to 6. Further, at a connecting portion between the water removing unit 4 and the cleaning unit 3 which is located on the rear side of the water removing unit 4, a carrier port 56 and its gate valve 57 are also provided.

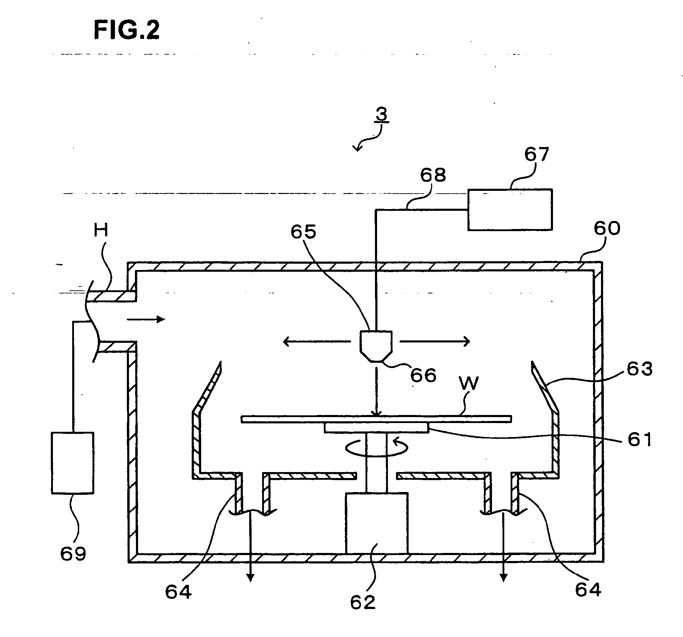

The cleaning unit 3 includes a chuck 61 for horizontally holding the wafer W, for example, in a housing 60 as shown in Fig. 2. The chuck 61 can hold the wafer W by suction, for example, by a not-shown suction mechanism. The chuck 61 is configured to be rotatable by a rotary motor 62. The rotary motor 62 can rotate the wafer W on the chuck 61 at a predetermined speed. Outside the chuck 61, a cup 63 is provided that surrounds the chuck 61. The cup 63 has an almost cylindrical shape with an open top face and a bottom. The liquid splashing from the wafer W due to rotation is received and collected by the cup 63. The bottom of the cup 63 is provided with, for example, drain ports 64 from which the solution collected by the cup 63 is drained.

- A cleaning nozzle 65 for supplying the cleaning solution to the wafer W can move by means of, for example, a not-shown moving arm from a waiting position outside the cup 63 to a processing position above the chuck 61. The cleaning nozzle 65 has, for example, an elongated shape longer than the diameter of the wafer W and has a plurality of discharge ports 66 linearly provided side by side along the longitudinal direction at the bottom. To the cleaning nozzle 65, a supply pipe 68 is connected which communicates with a cleaning solution supply source 67 located outside the housing 60. Accordingly, when the cleaning solution from the cleaning solution supply source 67 is supplied to the cleaning nozzle 65, the cleaning solution is discharged from the discharge ports 66 arranged in a straight line longer than the diameter of the wafer W. The cleaning solution can be supplied to the entire surface of the wafer W while the wafer is being rotated, thereby cleaning away impurities adhering to the surface of the wafer W. Further, to the housing 60, a gas supply pipe H is connected as a gas supply unit which communicates with a gas supply unit 69 located outside the housing 60. The gas supply unit 69 can supply a gas other than oxygen gas, for example, nitrogen gas into the housing 60 through the gas supply pipe H. Accordingly, the nitrogen gas can be supplied to maintain a low-oxygen atmosphere in the housing 60.

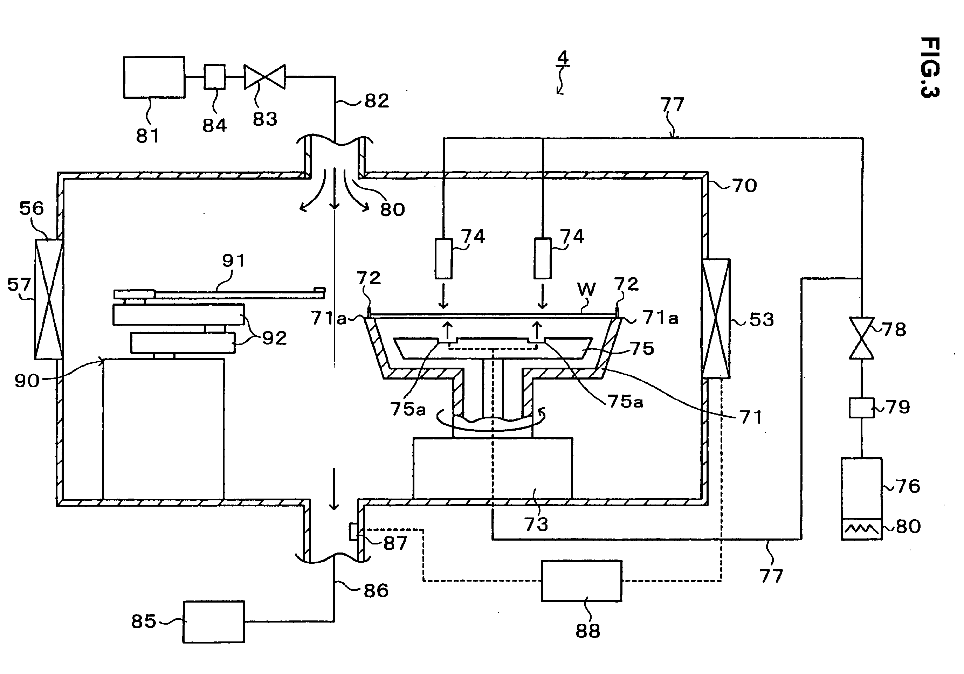

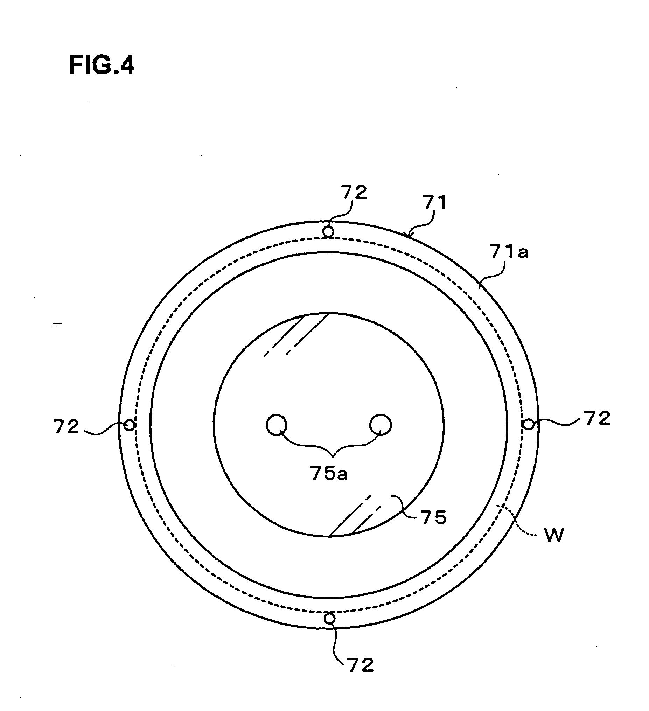

The water removing unit 4 has a housing 70 with an almost parallel-piped outside shape which can seal the inside as shown in Fig. 3. In the housing 70, a chuck 71 is provided which horizontally supports the wafer W. The chuck 71 is provided on the gate valve 53 side of the center of the housing 70, where the carrier section 7 is connected. The chuck 71 is formed, for example, in an almost cylindrical shape with a top face open and has an annular horizontal top end portion 71 a as seen from above. The chuck 71 supports the peripheral portion of the wafer W using the top end portion 71 a. On the top end portion 71 a of the chuck 71, a plurality of pins 72 are vertically provided for preventing positional displacement in the horizontal direction of the wafer W. The pins 72 are provided at regular intervals, for example, at positions along the outer shape of the wafer W mounted on the top end portion 71a as shown in Fig. 4, so that the pins 72 can hold the side face of the wafer W from the outside to prevent positional displacement of the wafer W. The chuck 71 is rotatable around the vertical axis by a rotary motor 73 as shown in Fig. 3, allowing the wafer W held on the chuck 71 to be rotated at a predetermined speed. Note that the chuck 7 and the rotary motor 73 constitute a rotary mechanism for the wafer W in this embodiment.

At positions opposed to the wafer W on the chuck 71, first gas supply nozzles 74 are provided each for supplying a high-temperature gas to the front face of the wafer W. The first gas supply nozzles 74 are provided, for example, at two positions equidistant from the center of the wafer W. In the hollow portion inside the chuck 71, a second gas supply nozzle 75 is provided. The top face of the second gas supply nozzle 75 is provided with, for example, two gas jet ports 75a, through which a high temperature gas can be supplied to the rear face of the wafer W supported on the chuck 71. The gas jet ports 75a are provided at regular intervals on the same circumference with the center of a circle on the center of the wafer W as seen in a plan view as shown in Fig. 4. Note that the first gas supply nozzles 74 and the second gas supply nozzle 75 are used as a high-temperature gas supply unit in this embodiment.

To the first and second gas supply nozzles 74 and 75, gas supply pipes 77 communicating with a gas supply unit 76 are connected as shown in Fig. 3. The gas supply pipes 77 are provided with a valve 78 and a massflow controller 79 so that the high-temperature gas in a predetermined amount can be jetted from the first and second gas supply nozzles 74 and 75. Further, the gas supply unit 76 includes, for example, a heating mechanism 80 for the high-temperature gas. Accordingly, the gas can be heated to a high temperature in the gas supply unit 76, and the high-temperature gas at a predetermined temperature can be jetted from the first and second gas supply nozzles 74 and 75. Note that nitrogen gas, for example, with an oxygen concentration of 4 ppm or less which never reacts with the surface of the wafer W is used as the high-temperature gas in this embodiment.

Further, the housing 70 is provided with a gas supply port 80 for supplying gas to the entire inside of the housing 70. To the gas supply port 80, a supply pipe 82 is connected as a gas supply unit communicating with a gas supply source 81 located outside the housing 70. The supply pipe 82 is provided with a valve 83 and a massflow controller 84. Note that nitrogen gas with an oxygen concentration of 4 ppm or less which is the same kind as the high-temperature gas jetted from the first and second gas supply nozzles 74 and 75 is used as the gas introduced through the gas supply port 80 in this embodiment.

To the bottom of the housing 70, an exhaust pipe 86 is connected as an exhaust unit communicating with a pressure reducing unit 85 such as a pump located outside the housing 70. The exhaust pipe 86 can exhaust the nitrogen gas in the housing 70. The exhaustion through the exhaust pipe 86 can reduce the pressure in the housing 70. The exhaust pipe 86 is provided with a water concentration sensor 87 as a water concentration measuring member. The measurement result of the water concentration sensor 87 can be outputted, for example, to a control unit 88 for controlling opening/closing of the gate valve 53 as a shutter. The control unit 88 controls opening/closing of the gate valve 53, for example, based on the water concentration in the housing 70. Accordingly, the control unit 88 can open the gate valve 53, for example, when the water concentration in the housing 70 decreases to the threshold value or less which has been previously set.

Adjacent to the chuck 71 and on the cleaning unit 3 side of the center of the housing 70, a wafer carrier 90 is provided which carries the wafer W between the chuck 71 and the cleaning unit 3. The wafer carrier 90 has, for example, a holding member 91 for holding the wafer W and an articulated arm 92 for supporting the holding member 91 and linearly moving it back and forth. The arm 92 is rotatable to be able to change the orientation of the holding member 91. Accordingly, the wafer carrier 90 can support the wafer W on the chuck 71 by the holding member 91, change its orientation, and then carry the wafer W into the cleaning unit 3 through the carrier port 56.

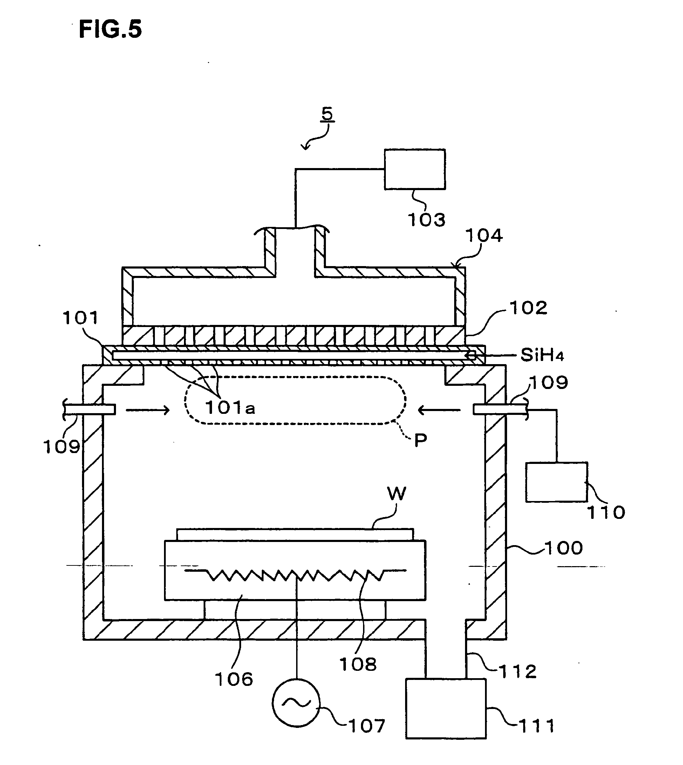

The first film forming unit 5 is, for example, a plasma processing unit for forming a gate insulating film on the surface of the wafer W using plasma. The first film forming unit 5 has a vacuum container 100, for example, in a cylindrical shape with an open top face and a bottom as shown in Fig. 5. At the opening portion on the top face of the vacuum container 100, a hollow gas supply unit 101 in a disk shape is provided in a manner to close the opening portion. The lower face of the gas supply unit 101 is formed with a number of gas supply holes 101 a through which a reaction gas introduced into the gas supply unit 101, for example, silane (SiH₄) gas is supplied into the vacuum container 100 in a shower form. On the upper side of the gas supply unit 101, an antenna 102 is provided. To the antenna 102, a coaxial waveguide pipe 104 is connected which communicates with a microwave feeder 103 located outside the vacuum container 100. The antenna 102 includes a plurality of through-holes 102a in the vertical direction, so that microwave propagated through the coaxial waveguide pipe 104 from the microwave feeder 103 is radiated into the vacuum container 100 via the through-holes 102a of the antenna 102 and the gas supply unit 101. The radiation of the microwave allows a plasma generation region P to be formed at the upper portion in the vacuum container 100.

At a position inside the vacuum container 100 and opposed to the gas supply unit 101, a mounting table 106 is provided on which the wafer is to be mounted. The mounting table 106 incorporates a heater 108 which generates heat, for example, by electricity fed from an AC power supply 107, so that the wafer W on the mounting table 106 can be heated by the heat generation of the heater 108. Near the top portion of the side wall of the vacuum container 100, gas supply pipes 109 are connected. A plurality of gas supply pipes 109 are annularly provided, for example, along the inner peripheral face of the vacuum container 100. The gas supply pipes 109 are connected to a supply source 110 of a reaction gas, for example, oxygen gas, rare gas, or the like. The introduction of the reaction gas from the gas supply pipes 109 and the aforementioned gas supply unit 101 allows the reaction gas to be supplied to the plasma generation region P and made plasma by the microwave from the antenna 102. To the bottom of the vacuum container 100, an exhaust pipe 112 is connected which leads to an exhauster 111 such as a turbo molecular pump so that the inside of the vacuum container 100 can be reduced to a predetermined pressure.

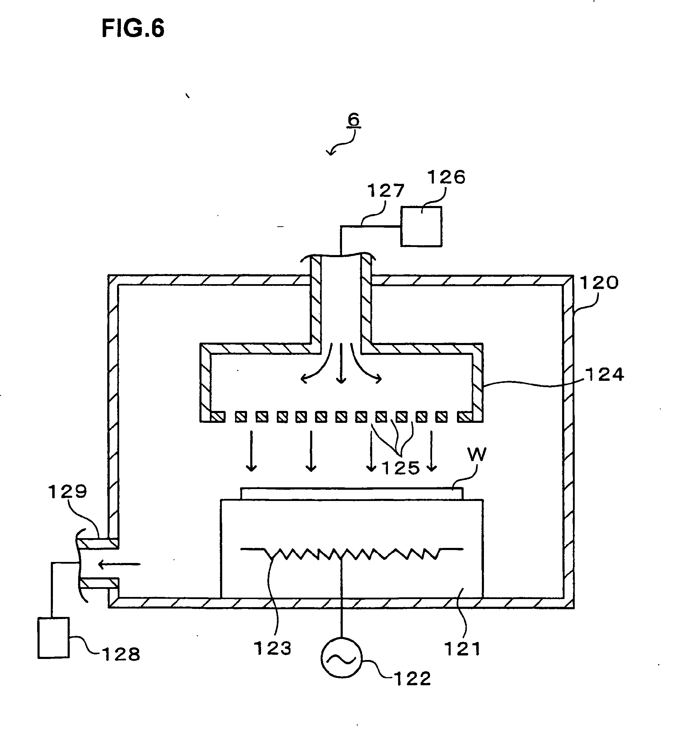

Next, the configuration of the second film forming unit 6 will be described. The second film forming unit 6 is, for example, a CVD processing unit for forming a gate electrode film on the wafer W. The second film forming unit 6 has a housing 120 whose can seal its inside as shown in Fig. 6, and a mounting table 121 on which the wafer W is mounted is provided in the housing 120. The mounting table 121 incorporates a heater 123 which generates heat by electricity fed from an AC power supply 122 located outside the housing 120. The wafer W on the mounting table 121 can be heated by the heat generation of the heater 123. The mounting table 121 is further provided with a not-shown rotary mechanism which can rotate the wafer W on the mounting table 121 at a predetermined rotation speed.

At a position at-the-upper portion-in the housing 120 and opposed to the mounting table 121, a gas supply head 124 is provided for supplying a reaction gas to the entire surface of the wafer W. The gas supply head 124 is formed, for example, in an almost cylindrical shape. The lower face of the gas supply head 124 is formed with a number of gas jet ports 125. To the center portion of the top face of the gas supply head 124, a gas introduction pipe 127 is connected which communicates with a gas supply unit 126 located outside the housing 120. In this embodiment, for example, silane gas is used as the gas to be supplied from the gas supply unit 126.

To the lower portion of the housing 120, an exhaust pipe 129 is connected which leads to an exhauster 128 such as a vacuum pump, so that exhaustion from the exhaust pipe 129 allows the atmosphere in the housing 120 to be exhausted and the pressure inside the housing 120 to be reduced.

As described above, the carry-in/out section 2, the carrier section 7, the cleaning unit 3, the water removing unit 4, the first film forming unit 5 and the second film forming unit 6 constituting the substrate processing system 1 can be individually atmosphere-controlled, resulting in atmosphere control of the entire inside of the substrate processing system 1.

The substrate processing system 1 is configured as described above, and the operation of the substrate processing system 1 will be described below. During processing of the wafer W, a dry nitrogen gas is supplied from the gas supply pipe 30 to the casing 21 of the carrier section 7 to maintain a low-oxygen atmosphere in the carrier section 7. Further, exhaustion from the exhaust pipe 35 is also performed to reduce the pressure in the carrier section 7 to a predetermined pressure. For example, the pressure in the carrier section 7 is maintained at a pressure higher than the pressures in the first film forming unit 5 and the second film forming unit 6. In this embodiment, film forming processing in the first film forming unit 5 is performed at about 1.33 Pa to 665 Pa, and film forming processing in the second film forming unit 6 is performed at about 1.33 Pa to 1330 Pa, and therefore a reduced-pressure atmosphere is maintained in the carrier section 7, for example, at a pressure of about 133 × 10² Pa that is higher than those pressures.

The nitrogen gas is supplied from the gas supply pipe H into the housing 60 of the cleaning unit 3 to maintain a low-oxygen atmosphere in the housing 60. The inside of the cleaning unit 3 is maintained, for example, at normal pressures, while the inside of the water removing unit 4 is maintained, for example, at a pressure between 133 × 10² Pa and about normal pressures, that is, between the pressure in the carrier section 7 and the pressure in the cleaning unit 3 by exhaustion from the exhaust pipe 86. As a result, the degree of pressure-reduction becomes higher in the cleaning unit 3, the water removing unit 4, the carrier section 7, and the first film forming unit 5 in that order, that is, in the order of carrying the wafer W. Further, nitrogen gas is supplied from the gas supply port 80 into the water removing unit 4 at all times to maintain a low-oxygen atmosphere in the water removing unit 4. Note that the pressure in the carrier chamber 11 is maintained at almost normal pressures. The plurality of gate valves 41, 53, 54, 55, and 57 in the substrate processing system 1 are usually closed, and opened only when the wafer W passes therethrough.

Once the cassette 12 is mounted on the cassette mounting table 10, one unprocessed wafer W is taken out of the cassette 12 by the wafer carrier 15 and carried to the alignment stage 14. The wafer W which has been subjected to alignment in the alignment stage 14 is carried into the carrier section 7 via the carrier port 40 and delivered to the wafer carrier mechanism 25. The wafer delivered to the wafer carrier mechanism 25 is carried into the water removing unit 4 via the carrier port 50 and delivered to the chuck 71. The wafer W delivered to the chuck 71 is then carried to the cleaning unit 3 by the wafer carrier 90.

In the cleaning unit 3, the cleaning solution is supplied onto the wafer W while the wafer W is being rotated to clean out the impurities such as organic substances and so on from the wafer W. The wafer W after the cleaning is carried, kept in the low-oxygen atmosphere, into the water removing unit 4 by the wafer carrier 90, and then supported on the chuck 71 as shown in Fig. 3.

When the wafer W is supported on the chuck 71, the chuck 71 is rotated by the rotary motor 73 to rotate the wafer W at a speed, for example, 2000 rpm or higher, preferably 3000 rpm or higher. Subsequently, nitrogen gas at a high temperature, for example, about 50°C to about 100°C is jetted from the first gas supply nozzles 74 and the second gas supply nozzle 75 so that the high temperature gas is jetted to the front face and the rear face of the rotated wafer W. The jet of the high-temperature gas evaporates and removes the water adhering to the both faces of the wafer W. In this event, the total supply amount of the high-temperature gas to be jetted to the wafer W may be obtained by calculating the molecular weight of the water adhering to the wafer W from the relative humidity in the room and using the quantity of heat required to evaporate the water of that molecular weight.

In the control unit 88, the water concentration sensor 87 is monitoring the water concentration in the water removing unit 4 at all times, so that the above-described high-temperature gas is supplied until the water concentration in the water removing unit 4 decreases to the previously set threshold value or less. Once the water concentration decreases to be less than the threshold value, the-supply of the high-temperature gas is stopped and the rotation of the wafer W is also stopped. The fact that the water concentration has decreased to be less than the threshold value is recognized as a trigger, the gate valve 53 is opened by the control unit 88.

When the gate valve 53 is opened, the holding member 26 of the wafer carrier mechanism 25 enters the water removing unit 4 and receives the wafer W and carries it out to the carrier section 7. Thereafter, the wafer carrier mechanism 25 moves on the rail 22 to the front of the first film forming unit 5 and carries the wafer W into the first film forming unit 5 via the carrier port 51. During the carriage, water never adheres to the wafer W since the wafer W passes through the dry atmosphere.

The wafer W carried into the first film forming unit 5 is mounted on the mounting table 106, and the reaction gas such as oxygen gas or silane (SiH₄) gas is then supplied from the gas supply pipes 109 and the gas supply unit 101 with the pressure in the vacuum container 100 being reduced and the reaction gas is made plasma by the microwave. Then, the plasma causes chemical reaction on the front face of the wafer W to form a gate insulating film such as a silicon oxide film or the like on the front face of the wafer W. The wafer W formed with the gate insulating film is carried into the carrier section 7 by the wafer carrier mechanism 25 and carried through the carrier section 7 to the second film forming unit 6.

In the second film forming unit 6, for example, silane gas being the reaction gas is supplied to the wafer W with the pressure in the housing 120 being reduced and the wafer W being heated, thereby causing chemical reaction on the front face of the wafer W to form a gate electrode film or the like of polycrystalline silicon or a metal material such as TaN, Ta, W, TiN.

Once the gate electrode film is formed, the wafer W is carried out to the carrier section 7 by the wafer carrier mechanism 25 and carried through the carrier section 7 to a position close to the carrier chamber 11. The wafer W is then carried into the carrier chamber 11 via the carrier port 40, and then retuned to the cassette 12 by the wafer carrier 15. Thus, a series of cleaning and film forming processing of the wafer W is finished.

According to the above embodiment, the water removing unit 4 is located adjacent to the cleaning unit 3 so that the dry atmosphere can be maintained in the carrier section 7 having the carrier path 20 from the water removing unit 4 to the first film forming unit 5. This allows water to be sufficiently removed in the water removing unit 4 and the wafer to be carried to the first film forming unit 5 while the above state is being maintained. As a result of this, film forming processing can be performed with the water being completely removed from the wafer W, and therefore the film forming processing is appropriately performed without interference by water.

The water removing unit 4 is provided with the first gas supply nozzles 74 and the second gas supply nozzle 75, thereby allowing the nitrogen gas at a high temperature to be supplied to both faces of the wafer W so as to completely remove water from the wafer W. The wafer W is rotated by the rotary motor 73 during the supply, so that the high-temperature gas can be uniformly supplied to the entire face of the wafer W, thereby removing water with more reliability. Further, since the nitrogen gas with an oxygen concentration of 4 ppm or less is used as the high-temperature gas, oxidation of the wafer W can be prevented to prevent deterioration of the wafer surface layer film. Further, since the gas supply pipe H is provided at the cleaning unit 3 to maintain a low-oxygen atmosphere in the housing 60 of the cleaning unit 3 and the gas supply pipe 82 is provided also at the water removing unit 4 to maintain a low-oxygen atmosphere in the housing 70, the wafer W can be kept in the low-oxygen atmosphere at all times during a period from adherence of water to the wafer W in the cleaning unit 3 to removal of the water in the water removing unit 4. This can prevent the wafer W which becomes apt to react with oxygen because of adherence of water from reacting with oxygen. In shorts, the wafer W can be prevented from oxidation in which the surface layer film of the wafer deteriorates.

Since the water concentration sensor 87 is provided at the exhaust pipe 86 of the water removing unit 4, it can be detected that water no longer exits in the water removing unit 4, namely, that the wafer W has no longer water thereon. Further, the control unit 88 is provided which controls opening/closing of the gate valve 53 based on the measurement result of the water concentration sensor 87, and thus can prevent the gate valve 53 from being opened by mistake and the wafer W from being carried into the film forming unit 5 before the water is removed from the wafer W.

Since the pressure reducing mechanism including the exhaust pipe 35 and the exhauster 34 is provided at the carrier section 7, the pressure in the carrier section 7 can be made higher than the pressures in the first film forming unit 5 and the second film forming unit 6 and lower than the pressure in the water removing unit 4. This can gradually accustom the wafer W to the reduced-pressure atmosphere during carriage of the wafer W to the first film forming unit 5 where processing is performed at a high reduced-pressure state. Consequently, breakage of the wafer W due to sudden change in pressure can be prevented. In terms of this, the water removing unit 4 is also maintained at a pressure lower than normal pressures in the cleaning unit 3, so that also when the wafer W is carried from the cleaning unit 3 to the carrier section 7, the peripheral atmosphere can be gradually reduced.

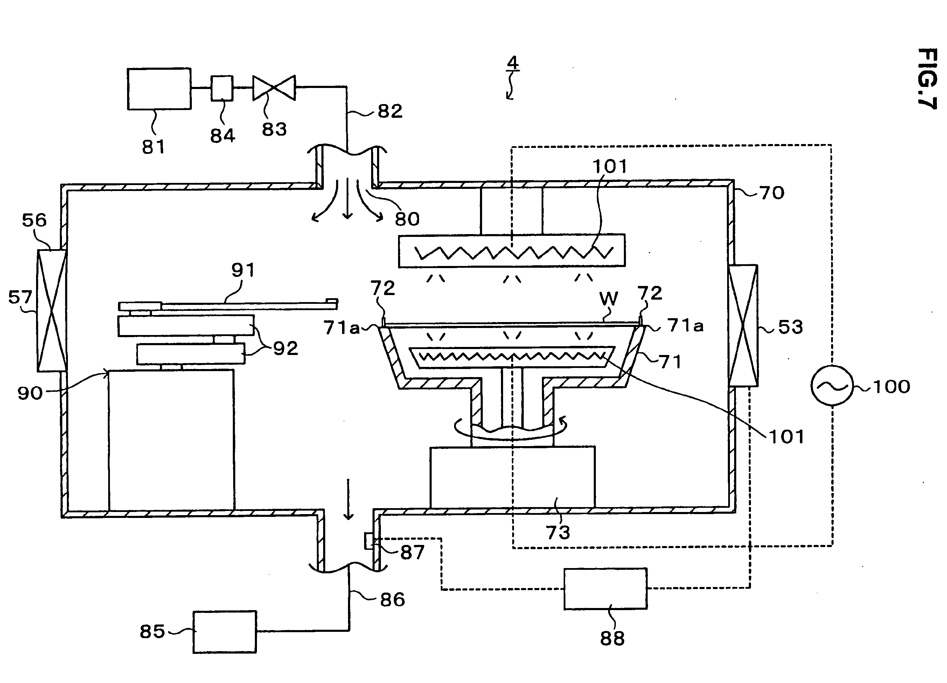

Although the removal of water in the water removing unit 4 is performed using the high-temperature gas from the first and second gas supply nozzles 74 and 75 in the above embodiment, the removal may be performed using a heater as a heating member for heating the wafer W with radiation heat. In this case, heaters 101 for generating heat by electricity fed from an AC power supply 100 are disposed, for example, at the upper face side and the lower face side of the wafer W as shown in Fig. 7. The heaters 101 are disposed at positions not in contact with the wafer W. When the water adhering to the wafer W is removed, radiation heat is supplied from the heaters 101 to both faces of the wafer W to heat the wafer W. In this case, the radiation heat heats the wafer W, the heat being more surely supplied to the entire face of the wafer W without unevenness can remove all the water adhering to the wafer W. Incidentally, the heating member for heating the wafer W is not limited to the heater, but may be an infrared lamp or one utilizing heat conduction for heating the wafer W by jetting heated gas.

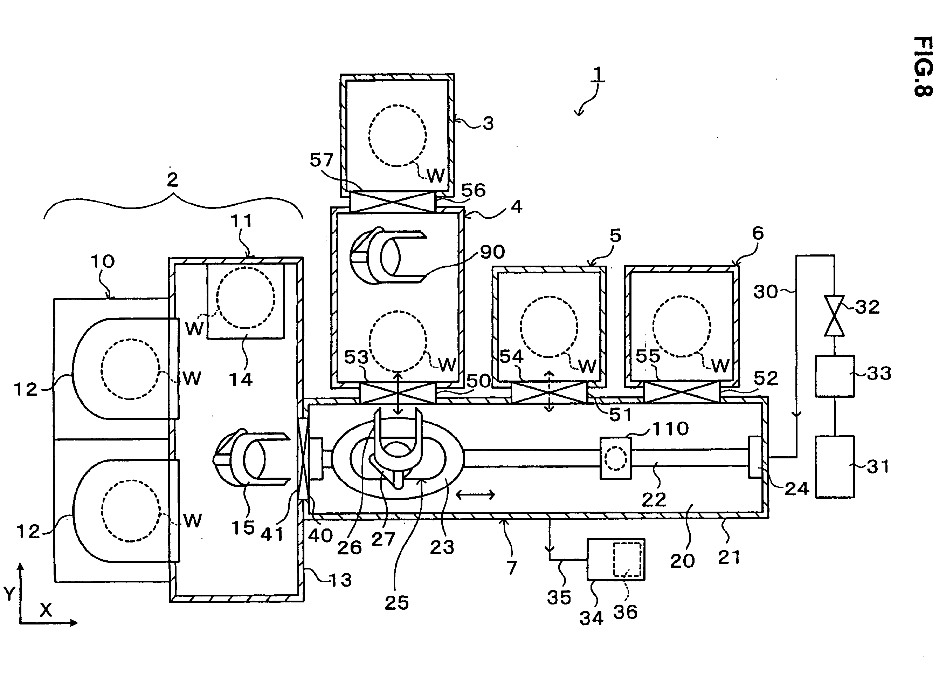

The substrate processing system 1 described in the above embodiment may include a film thickness measuring member for measuring the film thickness of a film formed by the film forming unit. For example, a film thickness measuring probe 110 as the film thickness measuring member for measuring the film thickness using laser light is provided on the carrier path 20 in the carrier section 7 as shown in Fig. 8. The film thickness measuring probe 110 is attached, for example, to the top face of the casing 21 to be able to apply the laser light downward from above. For example, when the wafer W formed with a gate insulating film in the first film forming unit 5 is carried through the carrier section 7 to the second film forming unit 6, the film thickness of the gate insulating film is measured by the film thickness measuring probe 110. Further, when the wafer W formed with a gate electrode film in the second film forming unit 6 is carried to the carry-in/out section 2, the film thickness of the gate electrode film is measured by the film thickness measuring probe 110. According to the substrate processing system 1, the film thickness inspection can be conducted in the same system with the film forming units. In addition, a poor condition in film thickness can be detected at an earlier stage, so that the film forming unit is immediately stopped and the recipe is modified, thereby avoiding defective wafers W from being manufactured in large quantities. Note that the location of the film thickness measuring probe is not limited to the carrier section 7, but the unit may be provided, for example, in each of the film forming units.

One example of the embodiment of the present invention has been described above, and the present invention, not limited to the example, can take various forms. The arrangement of the cleaning unit 3, the water removing unit 4, the first film forming unit 5, and the second film forming unit 6 in the substrate processing system 1 can be arbitrarily changed. Further, the first film forming unit 5 and the second film forming unit 6 are not limited to the units for forming the gate insulating film and the gate electrode film, but may be units for forming other films, for example, a sputtering unit and the like. Furthermore, the number of the film forming units is not limited to two but can be arbitrarily selected. Moreover, in place of the first and second film forming units, other processing units such as a metal forming unit using CVD or PVD, a barrier metal forming unit, an etching unit, and so on may be provided in the substrate processing system 1. In this case, the etching unit may be one using plasma having the same configuration as that of the first film forming unit 5. The substrate employed in the present invention, not limited to a wafer, may be other -substrates such as an LCD,- a glass substrate for photomask, and so on. Further, the substrate processing system in the present invention may be used not only to the above-described manufacture of a semiconductor device having a gate insulating film and a gate electrode film but also to manufacture of other semiconductor devices.

According to the present invention, the cleaned substrate can be carried to a subsequent processing unit with water being removed from the substrate, so that appropriate processing is performed in the processing unit without interference of water, resulting in improved yields. In addition, the wet-type unit such as the cleaning unit and the dry-type unit which needs to be isolated from water can be arranged in the same system -to- allow for continuous processing, leading to improved throughput.

### Industrial Applicability

The present invention is useful in a substrate processing system including a cleaning unit when completely removing water adhering to a substrate and carrying the substrate to a film forming unit with the water being removed.

### EXPLANATION OF CODES

1 SUBSTRATE PROCESSING SYSYTEM
3 CLEANING UNIT
4 WATER REMOVING UNIT
5 FIRST FILM FORMING UNIT
6 SECOND FILM FORMING UNIT
7 CARRIER SECTION
21 CASING
74 FIRST GAS SUPPLY NOZZLE
75 SECOND GAS SUPPLY NOZZLE
W WAFER

## Claims

1. A substrate processing system (1), comprising:
a cleaning unit (3) for cleaning a substrate with a cleaning solution;
a water removing unit (4) for removing water adhering to the substrate cleaned in said cleaning unit (3); a shutter (53) for opening/closing a carrier port (40) for the substrate between said water removing unit (4) and a carrier section (7); and
the carrier section (7) having a substrate carrier mechanism (25) for carrying the substrate from which water has been removed in said water removing unit (4) to another substrate processing unit or between other processing units through a dry atmosphere;
a carry-in/out section (2) having a substrate carrier (90) for carrying the substrate to be processed from a cassette; **characterized by**
a water concentration measuring member (87) for measuring a water concentration in said water removing unit (4);
a control unit (88) to which a measurement result of the water concentration is provided by said water concentration measuring member (87), for controlling opening/closing of said shutter (53) based on the measurement result.

2. The substrate processing system (1) as set forth in claim 1, wherein:
said cleaning unit (3) is connected with said water removing unit (4);
said water removing unit (4) is connected with said carrier section (7); and
said carrier section (7) is connected with said other processing unit.

3. The substrate processing system (1) as set forth in claim 1, wherein said water removing unit (4) has a heating member for heating the substrate.

4. The substrate processing system (1) as set forth in claim 3, wherein said heating member heats the substrate by radiation.

5. The substrate processing system (1) as set forth in claim 3, wherein said water removing unit (4) comprises a rotary mechanism (71, 73) for rotating the substrate.

6. The substrate processing system (1) as set forth in claim 1, wherein said water removing unit (4) comprises a high-temperature gas supply unit (74, 75) for supplying a high-temperature gas to the substrate.

7. The substrate processing system (1) as set forth in claim 6, wherein a gas with an oxygen concentration of 4 ppm or less is used as the high-temperature gas.

8. The substrate processing system (1) as set forth in claim 6, wherein said water removing unit (4) comprises a rotary mechanism (74, 75) for rotating the substrate.

9. The substrate processing system (1) as set forth in claim 1, wherein:
said water removing unit (4) comprises an exhaust unit (86) for exhausting a gas in said water removing unit (4); and
said water concentration measuring member (87) is provided in said exhaust unit (86).

10. The substrate processing system 1 as set forth in claim 1, wherein said water removing unit (4) comprises a pressure reducing unit for reducing the pressure in said water removing unit (4).

11. The substrate processing system (1) as set forth in claim 1, wherein said water removing unit (4) is provided with a gas supply unit for supplying a gas other than oxygen gas into said entire water removing unit (4).

12. The substrate processing system (1) as set forth in claim 1, wherein:
said carrier section (7) comprises a casing (21) covering a carrier path (20) of the substrate; and
said casing (21) is provided with a dry gas supply unit (30) for supplying a dry gas into said carrier path (20).

13. The substrate processing system (1) as set forth in claim 12, wherein the dry gas is a gas other than oxygen gas.

14. The substrate processing system (1) as set forth in claim 12, wherein said carrier section (7) is provided with a pressure reducing mechanism (34) for reducing the pressure of an atmosphere in said carrier path (20).

15. The substrate processing system (1) as set forth in claim 14, wherein said pressure reducing mechanism(34) comprises a control unit (36) capable of controlling the pressure in said carrier path (20) so that the pressure is between the pressure in said other processing unit and the pressure in said water removing unit (4).

16. The substrate processing system (1) as set forth in claim 1, wherein said other processing unit is a film forming unit (5, 6) for forming a film on the substrate.

17. The substrate processing system (1) as set forth in claim 16, further comprising:
a film thickness measuring member for measuring the film thickness of the film formed on the substrate in said film forming unit (5, 6).

18. The substrate processing system (1) as set forth in claim 1, wherein said other processing unit is an etching unit.

19. The substrate processing system (1) as set forth in claim 1, wherein said cleaning unit (3) is covered by a housing and comprises a gas supply unit for supplying a gas other than oxygen gas into said housing.

20. The substrate processing system (1) as set forth in claim 1, wherein said substrate processing system (1) is configured to atmosphere-control said entire substrate processing system (1).

## Patentansprüche

1. Substratverarbeitungssystem (1), das aufweist:
eine Reinigungseinheit (3), für das Reinigen eines Substrates mit einer Reinigungslösung;
eine Wasserentfernungseinheit (4), für das Entfernen von Wasser, das auf dem Substrat, das in der Reinigungseinheit (3) gereinigt worden ist, haftet;
einen Verschluss (53) zum Öffnen/Schließen einer Beförderungsluke (40) für das Substrat zwischen der Wasserentfernungseinheit (4) und einem Beförderungsabschnitt (7);
wobei der Beförderungsabschnitt (7) einen Substratbeförderungsmechanismus (25) für das Befördern des Substrats, von dem das Wasser in der Wasserentfernungseinheit (4) entfernt worden ist, in eine weitere Substratverarbeitungseinheit, oder zwischen anderen Bearbeitungseinheiten, durch eine trockene Atmosphäre;
einen Hinein-/Heraus-Beförderabschnitt (2), der einen Substratträger (90) aufweist, um das zu verarbeitende Substrat aus einer Kassette zu befördern; **gekennzeichnet durch**
eine Wasserkonzentrationsmesseinheit (87), um die Wasserkonzentration in der Wasserentfernungseinheit (4) zu messen; und
eine Steuereinheit (88), welcher ein Messergebnis der Wasserkonzentration von der Wasserkonzentrationsmesseinheit (87) bereitgestellt wird, um das Öffnen/Schließen des Verschlusses (53) auf Grundlage des Messergebnisses zu steuern.

2. Substratverarbeitungssystem (1) gemäß Anspruch 1, bei dem:
die Reinigungseinheit (3) mit der Wasserentfernungseinheit (4) verbunden ist;
die Wasserentfernungseinheit (4) mit dem Beförderungsabschnitt (7) verbunden ist; und
der Beförderungsabschnitt (7) mit der weiteren Verarbeitungseinheit verbunden ist.

3. Substratverarbeitungssystem (1) nach Anspruch 1, bei dem die Wasserentfernungseinheit (4) ein Heizelement für das Heizen des Substrats aufweist.

4. Substratverarbeitungssystem (1) nach Anspruch 3, bei dem das Heizelement das Substrat mittels Strahlung erwärmt.

5. Substratverarbeitungssystem (1) nach Anspruch 3, bei dem die Wasserentfernungseinheit (4) einen Rotationsmechanismus (71, 73) für die Rotation des Substrats aufweist.

6. Substratverarbeitungssystem (1) nach Anspruch 1, bei dem die Wasserentfernungseinheit (4) eine Hochtemperaturgaszuführeinheit (74, 75) aufweist, um das Substrat mit einem Hochtemperaturgas zu versorgen.

7. Substratverarbeitungssystem (1) nach Anspruch 6, bei dem ein Gas mit einer Sauerstoffkonzentration von 4 ppm oder weniger als das Hochtemperaturgas verwendet wird.

8. Substratverarbeitungssystem (1) nach Anspruch 6, bei dem die Wasserentfernungseinheit (4) einen Rotationsmechanismus (74, 75) für das Rotieren des Substrates aufweist.

9. Substratverarbeitungssystem (1) nach Anspruch 1, bei dem:
die Wasserentfernungseinheit (4) eine Ausströmeinheit (86) aufweist, um ein Gas in der Wasserentfernungseinheit (4) auszuströmen; und
die Wasserkonzentrationsmesseinheit (87) in der Ausströmeinheit (86) bereitgestellt ist.

10. Substratverarbeitungssystem (1) nach Anspruch 1, bei dem die Wasserentfernungseinheit (4) eine Druckminderungseinheit aufweist, um den Druck in der Wasserentfernungseinheit (4) zu verringern.

11. Substratverarbeitungssystem (1) nach Anspruch 1, bei dem die Wasserentfernungseinheit (4) mit einer Gaszufuhreinheit versehen ist, um ein von Sauerstoff verschiedenes Gas in der gesamten Wasserentfernungseinheit (4) zuzuführen.

12. Substratverarbeitungssystem (1) nach Anspruch 1, bei dem:
der Beförderungsabschnitt (7) ein Gehäuse (21) aufweist, das einen Beförderungspfad (20) des Substrats abdeckt; und
das Gehäuse (21) mit einer Trockengaszufuhreinheit (30) ausgestattet ist, um dem Beförderungspfad (20) ein Trockengas zuzuführen.

13. Substratverarbeitungssystem (1) nach Anspruch 12, bei dem das Trockengas ein von Sauerstoff verschiedenes Gas ist.

14. Substratverarbeitungssystem (1) nach Anspruch 12, bei dem der Beförderungsabschnitt (7) mit einem Druckminderungsmechanismus (34) versehen ist, um den Druck einer Atmosphäre in dem Beförderungspfad (20) zu vermindern.

15. Substratverarbeitungssystem (1) nach Anspruch 14, bei dem der Druckminderungsmechanismus (34) eine Steuereinheit (37) aufweist, die darauf ausgelegt ist, den Druck in dem Beförderungspfad (20) derart zu steuern, dass der Druck zwischen dem Druck in der weiteren Verarbeitungseinheit und dem Druck in der Wasserentfernungseinheit (4) liegt.

16. Substratverarbeitungssystem (1) nach Anspruch 1, bei dem die weitere Verarbeitungseinheit eine Schichtbildungseinheit (5, 6) ist, um eine Schicht auf dem Substrat zu bilden.

17. Substratverarbeitungssystem (1) nach Anspruch 16, das weiterhin aufweist:
eine Schichtdickenmesseinheit, um die Schichtdicke der auf dem Substrat in der Schichtbildungseinheit (5, 6) gebildeten Schicht zu bestimmen.

18. Substratverarbeitungssystem (1) nach Anspruch 1, bei dem die weitere Verarbeitungseinheit eine Ätzeinheit ist.

19. Substratverarbeitungssystem (1) nach Anspruch 1, bei dem die Reinigungseinheit (3) von einem Gehäuse überdeckt ist und eine Gaszufuhreinheit aufweist, um dem Gehäuse ein von Sauerstoff verschiedenes Gas zuzuführen.

20. Substratverarbeitungssystem (1) nach Anspruch 1, bei dem das Substratsverarbeitungssystem (1) darauf ausgelegt ist, das gesamte Substratsverarbeitungssystem (1) atmosphärisch zu steuern.

## Revendications

1. Système de traitement de substrat (1), comprenant :
une unité de nettoyage (3) pour le nettoyage d'un substrat avec une solution de nettoyage ;
une unité d'enlèvement de l'eau (4) pour enlever l'eau adhérant au substrat nettoyé dans ladite unité de nettoyage (3) ;
un volet (53) pour ouvrir/fermer un orifice porteur (40) pour le substrat situé entre ladite unité d'enlèvement de l'eau (4) et une section porteuse (7) ; et
la section porteuse (7) présentant un mécanisme porteur de substrat (25) pour transporter le substrat à partir duquel l'eau a été retirée dans ladite unité d'enlèvement de l'eau (4) dans une autre unité de traitement de substrat ou entre d'autres unités de traitement dans une atmosphère sèche ;
une section de report d'entrée/de sortie (2) présentant un porteur de substrat (90) pour transporter le substrat appelé à être traité à partir d'une cassette ; **caractérisé par**
un organe de mesure de la concentration de l'eau (87) pour mesurer une concentration d'eau dans ladite unité d'enlèvement de l'eau (4) ;
une unité de commande (88) à laquelle un résultat de mesure de la concentration d'eau est fourni par ledit organe de mesure de la concentration de l'eau (87) afin de contrôler l'ouverture/la fermeture dudit volet (53) en se basant sur le résultat de la mesure.

2. Système de traitement de substrat (1) tel que présenté dans la revendication 1, dans lequel :
ladite unité de nettoyage (3) est raccordée à ladite unité d'enlèvement de l'eau (4) ;
ladite unité d'enlèvement de l'eau (4) est raccordée à ladite section porteuse (7) ; et
ladite section porteuse (7) est raccordée à ladite autre unité de traitement.

3. Système de traitement de substrat (1) tel que présenté à la revendication 1, dans lequel ladite unité d'enlèvement de l'eau (4) est dotée d'un organe de chauffage pour le chauffage du substrat

4. Système de traitement de substrat (1) tel que présenté dans la revendication 3, dans lequel ledit organe de chauffage chauffe le substrat par radiation.

5. Système de traitement de substrat (1) tel que présenté à la revendication 3, dans lequel l'unité d'enlèvement de l'eau (4) comprend un mécanisme rotatif (71, 73) pour assurer la rotation du substrat.

6. Système de traitement de substrat (1) tel que présenté dans la revendication 1, dans lequel ladite unité d'enlèvement de l'eau (4) comprend une unité d'alimentation de gaz à haute température (74, 75) pour l'alimentation d'un gaz à haute température au substrat.

7. Système de traitement de substrat (1) tel que présenté à la revendication 6, dans lequel un gaz d'une concentration en oxygène de 4 ppm ou moins est utilisé à titre du gaz à haute température.

8. Système de traitement de substrat (1) tel que présenté à la revendication 6, dans lequel ladite unité d'enlèvement de l'eau (4) comprend un mécanisme de rotation (74, 75) pour assurer la rotation du substrat.

9. Système de traitement de substrat (1) tel que présenté à la revendication 1, dans lequel:
ladite unité d'enlèvement de l'eau (4) comprend une unité d'évacuation (86) pour l'évacuation d'un gaz dans ladite unité d'enlèvement de l'eau (4) ; et
ledit organe de mesure de la concentration de l'eau (87) est fourni dans ladite unité d'évacuation (86).

10. Système de traitement de substrat 1 tel que présenté dans la revendication 1, dans lequel ladite unité d'enlèvement de l'eau (4) comprend une unité de réduction de la pression destinée à la réduction de la pression dans ladite unité d'enlèvement de l'eau (4).

11. Système de traitement de substrat (1) tel que présenté à la revendication 1, dans lequel ladite unité d'enlèvement de l'eau (4) est dotée d'une unité d'alimentation de gaz pour l'alimentation d'un gaz autre que le gaz d'oxygène dans la totalité de l'unité d'enlèvement de l'eau (4).

12. Système de traitement de substrat (1) tel que présenté dans la revendication 1, dans lequel :
ladite section porteuse (7) comprend une enceinte (21) couvrant un chemin porteur (20) du substrat ; et
ladite enceinte (21) est dotée d'une unité d'alimentation de gaz sec (30) destinée à l'alimentation d'un gaz sec dans ledit chemin porteur (20).

13. Système de traitement de substrat (1) tel que présenté à la revendication 12, dans lequel le gaz sec est un gaz autre que le gaz d'oxygène.

14. Système de traitement de substrat (1) tel que présenté à la revendication 12, dans lequel ladite section porteuse (7) est dotée d'un mécanisme de réduction de la pression (34) pour diminuer la pression dans ledit chemin porteur (20).

15. Système de traitement de substrat (1) tel que présenté dans la revendication 14, dans lequel ledit mécanisme de réduction de la pression (34) comprend une unité de commande (36) capable de réguler la pression dans ledit chemin porteur (20) de manière à ce que la pression se situe entre la pression dans ladite autre unité de traitement et la pression dans ladite unité d'enlèvement de l'eau (4).

16. Système de traitement de substrat (1) tel que présenté dans la revendication 1, dans lequel ladite unité de traitement est une unité de formation d'un revêtement (5, 6) destinée à la formation d'un revêtement sur le substrat.

17. Système de traitement de substrat (1) tel que présenté dans la revendication 16, comprenant en outre :
un organe de mesure de l'épaisseur du revêtement destiné à mesurer l'épaisseur du revêtement formé sur le substrat de ladite unité de formation de revêtement (5, 6).

18. Système de traitement de substrat (1) tel que présenté dans la revendication 1, dans lequel ladite unité de traitement est une unité de gravure.

19. Système de traitement de substrat (1) tel que présenté à la revendication 1, dans lequel ladite unité de nettoyage (3) est couverte par un boîtier et comprend une unité d'alimentation de gaz pour l'alimentation d'un gaz autre que le gaz d'oxygène dans ledit boîtier.

20. Système de traitement de substrat (1) tel que présenté à la revendication 1, dans lequel ledit système de traitement de substrat (1) est configuré pour réguler le gaz atmosphérique de la totalité du système de traitement de substrat (1).
